# EUROPÄISCHE PATENTSCHRIFT

(11) **EP 2 740 336 B1**
(45) Veröffentlichungstag und Bekanntmachung des Hinweises auf die Patenterteilung: **22.04.2015**
(21) Anmeldenummer: 12746048.3
(22) Anmeldetag: 24.07.2012
(51) Int. Cl.: H05K 5/00, G01P 1/02

(54) **ELEKTRONIKANORDNUNG**
ELECTRONICS ARRANGEMENT
ENSEMBLE ÉLECTRONIQUE

(30) Priorität: 01.08.2011 DE 102011080170
(43) Veröffentlichungstag der Anmeldung: 11.06.2014
(73) Patentinhaber: Robert Bosch GmbH, 70442 Stuttgart (DE)
(72) Erfinder: MOSER, Manfred, 72768 Reutlingen (DE); WONNER, Mark, Suzhou 215021 (CN); CUPAL, Roland, 71706 Markgroeningen (DE)
(86) Internationale Anmeldenummer: PCT/EP2012/064484
(87) Internationale Veröffentlichungsnummer: WO 2013/017472

(56) Entgegenhaltungen:
- EP-A1- 1 630 561
- DE-C1- 19 840 014
- DE-C1- 19 841 258
- US-A- 5 767 404

## Beschreibung

Die Erfindung betrifft einen Schaltungsträger, der in einem erfindungsgemäßen Gehäuse befestigt werden kann, sowie eine Anordnung aus einem Schaltungsträger und einem Gehäuse mit einer verbesserten und besonders vibrationsunempfindlichen Fixierung des Schaltungsträgers in dem Gehäuse.

### Stand der Technik

Bei Elektronikanordnungen im Kraftfahrzeug, insbesondere bei elektronischen Steuergeräten, die vibrationsempfindliche elektronische Bauteile wie Sensorelemente enthalten, ist es wichtig, dass der Schaltungsträger, auf dem das vibrationsempfindliche elektronische Bauteil angeordnet und kontaktiert ist, möglichst fest in einem Gehäuse fixiert ist. Nur so kann gewährleistet werden, dass der Sensor Signale mit einem ausreichend großen Signal zu Rauschverhältnis liefert, um eine zuverlässige Funktion der Schaltung sicherzustellen. Besonders wichtig ist dies bei Steuergeräten für sicherheitsrelevante Systeme, beispielsweise für ein Airbag-System.

Beispielsweise aus US 20110019356 A1 ist bekannt einen Schaltungsträger durch mehrere Schrauben in einem Gehäuse zu fixieren. Der Schaltungsträger weist dazu Befestigungsöffnungen auf, durch die eine Schraube geführt und mit dem Gehäuse verschraubt wird. Durch die Schrauben wird eine Haltekraft auf den Schaltungsträger ausgeübt, die ausreicht, um starke Vibrationen des Schaltungsträgers zu vermeiden. Die Schrauben bewirken jedoch lokal, im Bereich der Befestigungsöffnungen eine mechanische Verspannung und eventuell eine lokale Verformung des Schaltungsträgers. Dadurch können in der unmittelbaren Umgebung der Befestigungsöffnungen keine Leiterbahnen und/oder elektrische Bauteile angeordnet werden, da ein sicherer elektrischer Kontakt nicht gewährleistet ist. Der Bereich um die Befestigungsöffnung auf dem Schaltungsträger, der nicht zur Bestückung verwendet werden kann, wird auch als Tabuzone bezeichnet.

Ein weiterer Nachteil dieser Lösung besteht darin, dass die Fixierung mit Schrauben unter Berücksichtigung der Materialkosten- und Prozesskosten nicht optimal ist, Kunststoffgehäuse mit speziellen Einlegebuchsen benötigt werden und bei der Fertigung zusätzliche Prozessschritte nötig sind.

Aus EP 984527 A2 ist bekannt, statt einer Schraubverbindung zwischen Gehäuse und Leiteplatte eine Klipsverbindung mit Spreizdomen zu verwenden. Dabei weist das Gehäuse Spreizdome mit einer entsprechenden Geometrie auf, auf die die Leiterplatte aufgesteckt wird. Ein Spreizdorn greift von der gegenüberliegenden Gehäuseseite in den jeweiligen Spreizdom ein, wodurch die Segmente des Spreizdoms radial nach außen gedrückt werden und eine Haltekraft auf die Leiterplatte ausüben. Die Leiterplatte wird dabei an vier, im Bereich der Ecken der Leiterplatte angeordneten Befestigungsstellen an dem Gehäuse fixiert. Versuche haben ergeben, dass eine derartige Fixierung eines Schaltungsträgers in einem Gehäuse nicht ausreicht um eine Fixierung der Leiterplatte zu erzielen, die ausreicht, um ein auf der Leitplatte kontaktiertes Sensorelement mit einem ausreichend hohen Signal zu Rausch-Verhältnis zu betreiben. Vibrationen des Gehäuses übertragen sich auf die Leiterplatte und regen diese zu Eigenschwingungen an. Diese Eigenschwingungen wirken sich störend auf das Sensorelement aus und beeinträchtigen dessen Signalqualität.

Die EP 1 630 561 A1 zeigt eine im Wesentlichen quadratische Leiterplatte mit einem darauf montierten Beschleunigungssensor. Zur Befestigung der Leiterplatte in einem Gehäuse sind an den vier Seitenkanten der Leiterplatte mittig platzierte Einkerbungen vorgesehen, in die entsprechenden Vorsprünge des Gehäuses eingreifen und die Leiterplatte so fixieren.

Die DE 198 41 258 C1 zeigt ein Steuergerät mit einer mit zwei Beschleunigungssensoren bestückten Leiterplatte. Die Leiterplatte wird an ihrem Umfangsrand durch einen Deckel eines Gehäuses gehalten. Der Deckel ist weiterhin durch die Leiterplatte hindurch mit Vorsprüngen verschraubt, die vom Boden des Gehäuses vorstehen. Die Beschleunigungssensoren sind derart angeordnet, dass ihre Empfindlichkeitsrichtung in Richtung der Verbindungslinie zwischen den zugehörigen Vorsprüngen liegt.

Die US 5 767 404 A beschreibt einen Bewegungssensor für ein Fahrzeug. Ein Sensorelement ist in einem Gehäuse angeordnet und mittels einer flexiblen Leiterplatte mit einer Hybridschaltung kontaktiert. Um eine bessere Biegsamkeit der flexiblen Leiterplatte zu erzielen weist diese einen Schlitz im Biegebereich auf.

Die DE 198 40 014 C1 beschreibt die Befestigung einer gelochten Schaltungsplatte auf einem Kunststoffträger mittels eines Spreizdornes, der vier Nietbackensegmente aufweist, die als Schnapphaken ausgeführt sind.

### Offenbarung der Erfindung

Die Erfindung hat den Vorteil, dass eine Befestigung eines Schaltungsträgers in einem Gehäuse erzielt wird, die den Betrieb eines Sensorelements auch wenn starken Vibrationen des Gehäuses erlaubt, wie sie beispielsweise in einem Kraftfahrzeug auftreten können. Damit kann eine erfindungsgemäße Schaltungsanordnung beispielsweise für ein Steuergerät für ein Airbag-System eingesetzt werden.

Erfindungsgemäß ist ein Gehäuse mit einem Gehäuseelement vorgesehen, das Befestigungselemente für einen Schaltungsträger aufweist. Mindestens zwei der Befestigungselemente sind derart zueinander angeordnet, dass sie zusammen eine Gruppe bilden. Erfindungsgemäß ist eine solche Gruppe dadurch definiert, dass die Abstände zwischen jeweils zwei der Befestigungselemente, die einer Gruppe angehören, kleiner sind als die Abstände zwischen jedem Befestigungselement einer Gruppe und jedem weiteren Befestigungselement, das nicht der Gruppe angehört. Das Gehäuse weist also Befestigungselemente auf, die benachbart zueinander angeordnet sind.

Erfindungsgemäß ist ein Schaltungsträger vorgesehen, der Befestigungsöffnungen aufweist, die korrespondierend zu den Befestigungselementen des Gehäuses angeordnet sind und demzufolge ebenfalls in Gruppen zueinander angeordnet sind. Es sind demnach mindestens zwei Befestigungsöffnungen derart angeordnet, dass die Abstände zwischen den Befestigungsöffnungen, die der Gruppe angehören, kleiner sind als die Abstände zwischen jeder Befestigungsöffnung der Gruppe und jeder Befestigungsöffnung, die nicht der Gruppe angehört.

Insbesondere, wenn nur eine Gruppe von Befestigungsöffnungen in dem Schaltungsträger vorgesehen ist, ergibt sich dadurch eine asymmetrische Anordnung der Befestigungsöffnungen bezüglich einer Mittelachse des Schaltungsträgers.

Die Positionen der Befestigungsöffnungen des Schaltungsträgers entsprechen den Positionen der Befestigungselemente des Gehäuses, so dass erfindungsgemäß aus beiden eine Schaltungsanordnung, beispielsweise ein elektronisches Steuergerät zusammengesetzt werden kann. Dabei wirken die Befestigungselemente des Gehäuses mit den Befestigungsöffnungen des Schaltungsträgers derart zusammen, dass Befestigungsstellen ausgebildet werden, an denen der Schaltungsträger in dem Gehäuse fixiert ist. Jede Befestigungsstelle ist durch eine Befestigungsöffnung des Schaltungsträgers und mindestens ein Befestigungselement des Gehäuses gebildet.

Die geringen Abstände der Befestigungsstellen, die jeweils durch eine Gruppe von Befestigungsöffnungen des Schaltungsträgers und Befestigungselementen des Gehäuses gebildet werden, bewirken, dass im Bereich des Schaltungsträgers, der zwischen den Befestigungsöffnungen liegt, Schwingungen in einem im Vergleich zum Stand der Technik geringerem Maß von dem Gehäuse auf den Schaltungsträger übertragen werden können. Die Frequenzen der Schwingungen werden durch die geringen Abstände zu höhern Werten verschoben, die sich nicht mehr störend auf elektronische Bauteile auswirken, die in diesem Bereich des Schaltungsträgers angeordnet sind. Zusätzlich wird durch die Mehrzahl der Befestigungsstellen, die eine Gruppe bilden, eine stärkere Fixierung erzielt, so dass Schwingungen in diesem Bereich stärker gedämpft werden. Vor allem Schwingungen im Bereich von weniger als 8 kHz werden durch die erfindungsgemäße Anordnung der Befestigungsstellen effizient gedämpft. Es wird demnach durch die Anordnung der Befestigungsstellen eine mechanische Entkopplung des Bereichs des Schaltungsträgers erzielt.

Bevorzugt ist eine Gruppe von Befestigungsstellen aus mindestens drei Befestigungselementen des Gehäuses und drei korrespondierenden Befestigungsöffnungen des Schaltungsträgers aufgebaut. Die drei Befestigungsstellen liegen nicht auf einer gemeinsamen Verbindungslinie und spannen demnach einen Bereich zwischen sich auf. Dieser Bereich ist besonders geeignet um auf dem Schaltungsträger ein vibrationsempfindliches elektronisches Bauteil, anzuordnen.

In einer bevorzugten Ausführung der Erfindung umfasst das Gehäuseelement mehrere, insbesondere zwei, Gruppen von Befestigungselementen. Jeder Gruppe kann ein separates Sensorelement oder anderes vibrationsempfindliches Bauteil zugeordnet werden.

Besonders vorteilhaft ist eine Ausführung der Erfindung, bei der der Abstand zwischen zwei Befestigungselementen derselben Gruppe höchstens halb so groß ist wie der Abstand zwischen einem der Befestigungselemente der Gruppe und jedem anderen Befestigungselement, das nicht der Gruppe angehört. Kleinere Abstände führen zu höheren und damit weniger störenden Eigenfrequenzen von Vibrationen des Schaltungsträgers. Weiterhin wird durch die relativ geringen Abstände eine stabilere Fixierung erzielt. Es sind jedoch die absoluten Abmessungen des Gehäuses bzw. der Schaltungsanordnung zu beachten.

Die Befestigungselemente und Befestigungsöffnungen können auf verschiedene Weisen ausgestaltet sein, um eine erfindungsgemäße Fixierung des Schaltungsträgers in dem Gehäuse zu erzielen. So sind beispielsweise Schraubverbindungen, Nietverbindungen, Klebverbindungen oder Verbindungen durch Heiß/Kaltverstemmen oder Laserschweißen denkbar. Besonders bevorzugt sind die Befestigungselemente eines Gehäuseelements als Spreizdome ausgebildet oder weisen mindestens einen Spreizdom auf. Unter einem Spreizdom wird im Allgemeinen eine Ausbildung des Befestigungselements verstanden, bei der das Befestigungselement dornartig aufgebaut ist und mehrere, durch vertikale Schlitze getrennte Segmente aufweist, die elastisch verformbar sind. Aus dem Stand der Technik sind derartige Befestigungselemente auch als Spreiznieten bezeichnet. Derartige Spreiznieten, dienen bekanntlich zum Herstellen einer nichtlösbaren Verbindung zweier Bauteile, wobei die Kraftübertragung primär durch Formschluss zustande kommt. Vorzugsweise sind die Spreizdome einstückig an das Gehäuseelement angeformt. Zur Befestigung des Schaltungsträgers mit dem Gehäuseelement wird der Spreizdom in die entsprechende Befestigungsöffnungen des Schaltungsträgers eingesteckt, woraufhin durch Einschlagen bzw. Eindrücken eines Fixierdoms (auch als Spreizdorn bezeichnet) der segmentierte Schaft des Spreizdoms auseinandergetrieben wird, so dass dieser in der Befestigungsöffnung des Schaltungsträgers fixiert wird.

In einer besonders bevorzugten Ausführung weist der Spreizdom an seinem freien Ende einen Schnapphaken auf. Der Schnapphaken ist an mindestens einem der Segmente des Spreizdoms ausgebildet und bewirkt ein definiertes Einrasten des Schaltungsträgers beim Einstecken des Spreizdoms.

Auf dem Schaltungsträger ist bevorzugt im Bereich zwischen den Befestigungsöffnungen einer Gruppe ein elektronisches Bauelement, angeordnet, das insbesondere vor Vibrationen geschützt werden muss. Dabei kann es sich insbesondere um ein Sensorelement, wie beispielsweise ein Beschleunigungssensorelement oder ein Drehratensensorelement handeln. Die Befestigungsöffnungen, die das Sensorelement umgeben, sind bevorzugt im Randbereich des Schaltungsträgers angeordnet. Alternativ können das Sensorelement und die umgebenden Befestigungsöffnungen aber auch in jeder beliebigen, der jeweiligen Anwendung angepassten Position des Schaltungsträgers angeordnet sein.

Es können Sensorelemente eingesetzt werden, die eine Vorzugsachse aufweisen. So bestimmt beispielsweise bei Beschleunigungssensoren die Vorzugsachse die Richtungskomponente der Beschleunigung, die von dem Sensorelement erfasst wird. Beim Einsatz in einem Kraftfahrzeug unterscheidet man beispielsweise die Beschleunigungskomponente x in Fahrtrichtung und die Komponente y quer zur Fahrtrichtung. Ein Beschleunigungssensor, dessen Vorzugsachse in x-Richtung ausgerichtet ist, erfasst die Beschleunigung in Fahrtrichtung. Ein Beschleunigungssensor, dessen Vorzugsachse in y-Richtung ausgerichtet ist, erfasst die Beschleunigung quer zur Fahrtrichtung. Mit einer Ausrichtung des Sensorelements von 45° im Bezug auf die x- oder y-Richtung lassen sich beide Richtungskomponenten der Beschleunigung erfassen. Eine analoge Betrachtung gilt auch für Drehratensensoren.

Die erfindungsgemäß vorgesehenen Befestigungsöffnungen sind bevorzugt in x und/oder y-Richtung ausgerichtet, so dass Verbindungslinien zwischen zwei Befestigungsöffnungen, die einer Gruppe angehören, in x-Richtung oder in y-Richtung oder in einem Winkel von 45° zur y- oder x-Richtung verlaufen. Die Vorzugsachse des Sensorelements ist dann bevorzugt so ausgerichtet, dass sie zu einer Verbindungslinie zwischen zwei Befestigungsöffnungen, die das Sensorelement umgeben, parallel verläuft.

Die auf den Schaltungsträger übertragenen Schwingungen hängen außerdem von der Einbaulage des Schaltungsträgers ab. Dies wird bevorzugt durch die Anordnung der Befestigungsstellen berücksichtigt.

Bei Anwendungen die mehrere vibrationsempfindliche elektronische Bauelemente vorsehen, können erfindungsgemäß mehrere Gruppen von Befestigungsöffnungen auf dem Schaltungsträger angeordnet sein, wobei jede Gruppe von Befestigungsöffnungen ein vibrationsempfindliches elektronisches Bauelement umgibt. Alternativ oder zusätzlich können in dem Bereich, der von einer Gruppe von Befestigungsöffnungen aufgespannt wird, auch mehrere elektronische Bauelemente angeordnet sein.

In einer bevorzugten Ausführung ist eine Gruppe von drei Befestigungsöffnungen des Schaltungsträgers derart angeordnet, dass die Befestigungsöffnungen die Ecken eines, insbesondere rechtwinkligen, Dreiecks bilden.

In einer alternativen Ausführung ist eine Gruppe von vier Befestigungsöffnungen des Schaltungsträgers derart angeordnet, dass die Befestigungsöffnungen die Ecken eines Rechtecks bilden.

Bevorzugt ist ein vibrationsempfindliches elektronisches Bauelement an einer Position im Bereich der Befestigungsstellen einer Gruppe auf dem Schaltungsträger angeordnet, an der die Schwingungen, zu denen der Schaltungsträger angeregt werden kann, stark gedämpft sind. An welchen Stellen des Schaltungsträgers sich Minima oder Maxima der Schwingungen ausbilden, hängt unter anderem von der Anordnung der Befestigungsstellen zueinander und der Ausrichtung der Befestigungsstellen relativ zur Einbaulage des Schaltungsträgers ab.

Um zusätzlich den Einfluss höherer Schwingungsfrequenzen auf die Schaltungsanordnung zu reduzieren, weist der Schaltungsträger vorteilhaft zusätzlich Freifräsungen oder zusätzliche Massen, zum Beispiel in Form von Kleberpunkte auf. Damit lässt sich das Frequenzverhalten des Schaltungsträgers im Bereich eine Gruppe von Befestigungselemente gezielt einstellen, insbesondere für Schwingungsfrequenzen von mehr als 8 kHz bis mehr als 25 kHz. Die Freifräsungen sind vorzugsweise in Form von Schlitzen oder Aussparungen, die erfindungsgemäß im Bereich der Position des elektronischen Bauelements in dem Schaltungsträger vorgesehen werden, ausgebildet.

Das elektronischen Bauelements ist bevorzugt im Bereich des Schwerpunkts einer Gruppe von Befestigungsöffnungen angeordnet, da in diesem Bereich eine möglichst gleichmäßige Dämpfung der Schwingungen des Schaltungsträgers vorliegt.

Eine erfindungsgemäße Schaltungsanordnung wird gebildet indem ein erfindungsgemäß ausgestalteter Schaltungsträger in einem erfindungsgemäß ausgebildeten Gehäuse befestigt wird. Dazu wirken die Befestigungselemente des Gehäuses mit den Befestigungsöffnungen des Schaltungsträgers derart zusammen, dass Befestigungsstellen ausgebildet werden, an denen der Schaltungsträger in dem Gehäuse fixiert ist. Jede Befestigungsstelle ist durch eine Befestigungsöffnung des Schaltungsträgers und mindestens ein Befestigungselement des Gehäuses gebildet.

In einer Ausführung, bei der die Befestigungselemente eines Gehäuseelements mit Spreizdomen ausgebildet sind, ist bevorzugt ein zusätzliches Gehäuseelement mit zweiten Befestigungselementen vorgesehen, wobei die zweiten Befestigungselemente als Fixierdome ausgebildet sind. Bei Zusammenfügen des Gehäuses und des Schaltungsträgers, wird der Schaltungsträger zunächst auf die Spreizdome aufgesteckt. Dann wird das zweite Gehäuseelement aufgesetzt, wobei die Fixierdome in die Spreizdome eingreifen und diese auseinanderdrücken. Dadurch wird eine horizontale Haltekraft auf den Schaltungsträger ausgeübt.

### Zeichnungen

Figur 1 zeigt ein Gehäuseelement nach einem Ausführungsbeispiel der Erfindung im Schnitt und in Draufsicht.
Figur 2 zeigt schematisch einen Schaltungsträger nach einem ersten Ausführungsbeispiel der Erfindung. Figur2 a zeigt einen Ausschnitt aus einem Schaltungsträger nach dem ersten Ausführungsbeispiel der Erfindung.
Figur 3 zeigt schematisch einen Ausschnitt eines Schaltungsträgers nach einem zweiten Ausführungsbeispiel der Erfindung.
Figur 4 zeigt einen Ausschnitt einer erfindungsgemäßen Schaltungsanordnung.
Figuren 5a und 5b zeigen schematisch Ausschnitte aus Schaltungsträgern nach alternativen Ausführungen der Erfindung.

### Ausführungen der Erfindung

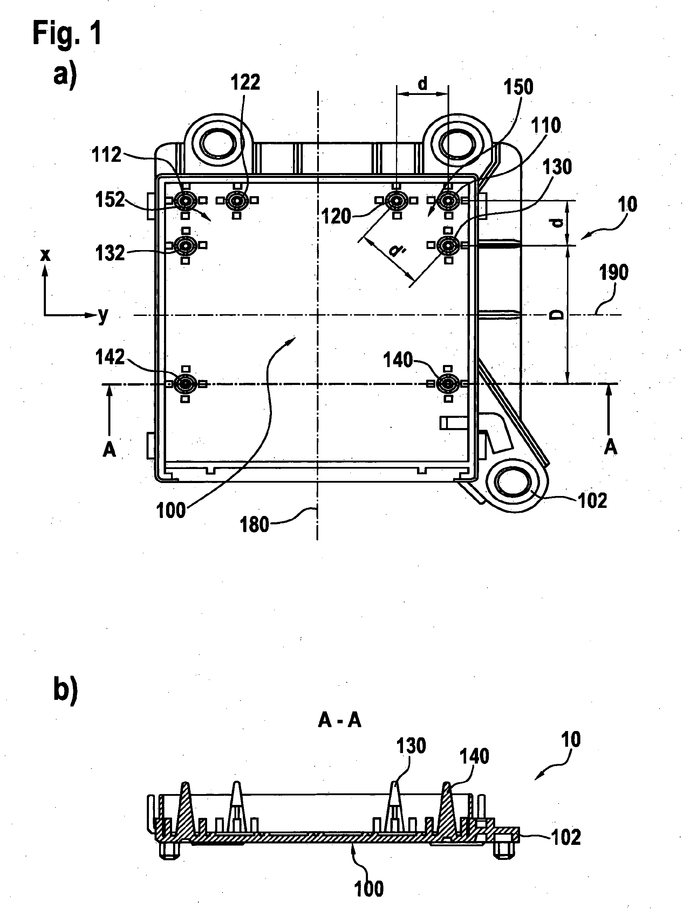

In Figur 1a und Figur 1b ist ein Gehäuseelement 10 eines erfindungsgemäßen Gehäuses dargestellt. Das Gehäuseelement weist einen flächig ausgebildeten Befestigungsbereich 100 auf. Am Rand des Gehäuseelements sind Öffnungen 102 ausgebildet mit denen das Gehäuseelement 10 an einer tragenden Struktur, beispielsweise einem Kraftfahrzeug, montiert werden kann. In dem Befestigungsbereich 100 sind insgesamt acht Befestigungselemente 110, 112, 120, 122, 130, 132, 140, 142 angeordnet. Die Befestigungselemente 110, 112, 120, 122, 130, 132, 140, 142 sind einteilig mit dem Gehäuseelement 10 ausgebildet und weisen Spreizdome auf. Die Befestigungselemente 110, 120, 130 sind als Gruppe 150 angeordnet. Dabei sind die Abstände d bzw. d' zwischen jeweils zwei der Befestigungselemente 110, 120, 130 der Gruppe 150 kleiner als jeder Abstand D zwischen einem Befestigungselemente 110, 120, 130 der Gruppe 150 und jedem Befestigungselement 112, 122, 132, 140, 142, das nicht der Gruppe 150 angehört. Die Befestigungselemente 110, 120, 130 der Gruppe 150 sind so angeordnet dass sie die Ecken eines rechtwinkligen Dreiecks bilden. Weiterhin wird eine zweite Gruppe 152 von den Befestigungselementen 112, 122, 132 gebildet. Die beiden Befestigungselemente 140 und 142 gehören keiner Gruppe an.

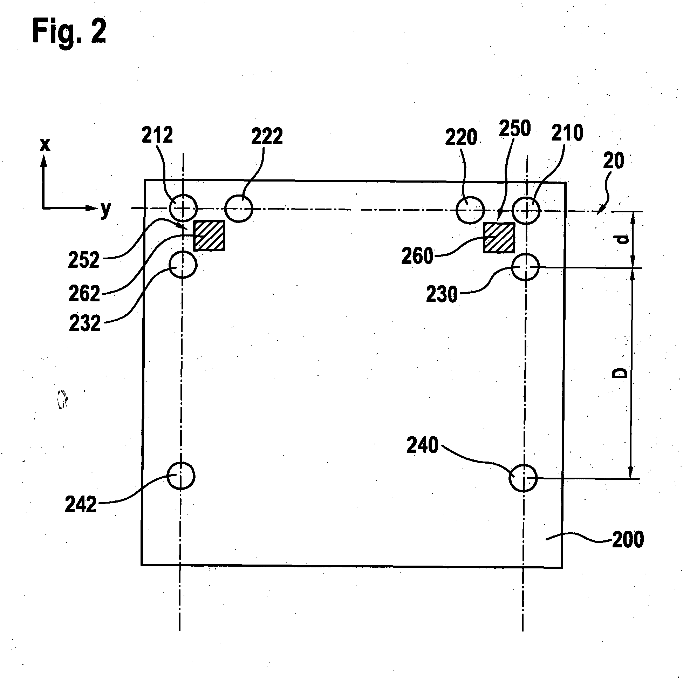

Figur 2 stellt einen Schaltungsträger 20 dar, der geeignet ausgestaltet ist, um in dem Gehäuseelement 10 aus Figur 1 fixiert zu werden. Der Schaltungsträger 20 umfasst eine Leiterplatte 200, die im Wesentlichen deckungsgleich mit dem Befestigungsbereich 100 des Gehäuseelements ausgebildet ist. Es ist auch möglich, eine Leiterplatte vorzusehen, deren Fläche kleiner als die des Befestigungsbereichs 100 ausgebildet ist. Die Leiterplatte 200 weist acht Befestigungsöffnungen 210, 212, 220, 222, 230, 232, 240, 242 auf. Die Befestigungsöffnungen 210, 212, 220, 222, 230, 232, 240, 242 sind als kreisförmige Bohrungen in der Leiterplatte 200 ausgebildet. Die Positionen der Befestigungsöffnungen 210, 212, 220, 222, 230, 232, 240, 242 auf der Leiterplatte 200 entsprechen den Positionen der Befestigungselemente 110, 112, 120, 122, 130, 132, 140, 142 in dem Gehäuseelement 10. Die Leitplatte kann demnach auf die Befestigungselemente des Gehäuses aufgesteckt werden. Analog zur Anordnung der Befestigungselemente 110, 112, 120, 122, 130, 132 in dem Gehäuseelement 10 sind die Befestigungsöffnungen 210, 212, 220, 222, 230, 232 in zwei Gruppen 250 und 252 angeordnet. Die erste Gruppe 250 umfasst die Befestigungsöffnungen 210, 220 und 230. Die zweite Gruppe 252 umfasst die Befestigungsöffnungen 212, 222 und 232. Für die einer Gruppe angehörenden Befestigungsöffnungen gilt, dass jeweils, dass die Abstände zweier Befestigungsöffnungen, die der selben Gruppe angehören kleiner sind als jeder Abstand einer Befestigungsöffnung einer Gruppe und jeder Befestigungsöffnung, die nicht dieser Gruppe angehört. So ist beispielsweise der Abstand d zwischen den Befestigungsöffnungen 210 und 230 aus Gruppe 250 geringer als der Abstand D zwischen Befestigungsöffnung 230 und Befestigungsöffnung 240. Auf der Leiterplatte sind aus Gründen der Übersichtlichkeit nicht dargestellte Leiterbahnen und elektronische Bauteile angeordnet. Im Bereich zwischen den Befestigungsöffnungen 210, 220 und 230 ist ein elektronisches Sensorelement 260 mit einem Beschleunigungssensor angeordnet. Durch die Anordnung der Befestigungsöffnungen 210, 220 und 230 ist dieser Bereich erfindungsgemäß vor Vibrationen geschützt, die die Funktion des Sensorelements 260 beeinträchtigen könnten. Das Sensorelement 260 ist derart ausgerichtet, dass seine Außenkanten parallel zu der Verbindungslinie der Befestigungsöffnungen 210 und 220 und der Verbindungslinie der Befestigungsöffnungen 210 und 230. Die gedachten Verbindungslinien verbinden dabei die Mittelpunkte der jeweiligen Befestigungsöffnungen. Alternativ zur dargestellten Ausrichtung des Sensorelements 260 in x-Richtung ist auch eine Ausrichtung des Sensorelements 260 in 45°, d.h. parallel zur Verbindungslinie 220 und 230, oder in y-Richtung möglich, abhängig von den zu erfassenden Richtungskomponenten der Beschleunigung.

Alternativ oder zusätzlich ist im Bereich der zweiten Gruppe 252 von Befestigungsöffnungen 212, 222 und 232 ein zweites elektronisches Sensorelement 262 angeordnet. Weiterhin sind auf dem Schaltungsträger 20 noch Leiterbahnen und elektrische sowie elektronische Bauelemente angeordnet, die aus Gründen der Übersichtlichkeit nicht dargestellt sind.

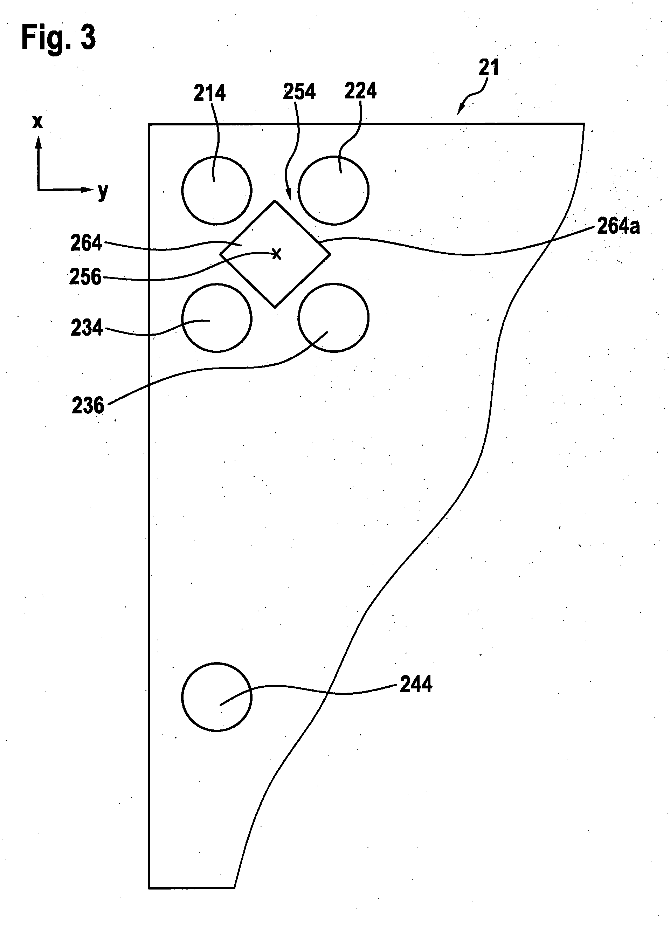

Figur 3 zeigt eine alternative Ausführung eines erfindungsgemäßen Schaltungsträgers 21. Der Schaltungsträger 21 weist eine Gruppe 254, bestehend aus vier Befestigungsöffnungen 214, 224, 234 und 236 auf. Die Befestigungsöffnungen 214, 224, 234 und 236 sind derart angeordnet dass sie die Ecken eines Rechtecks bilden. Im Bereich des Schwerpunkts 256 des Rechtecks ist ein elektronisches Sensorelement 264 angeordnet. Durch die Anordnung der Befestigungsöffnungen 214, 224, 234 und 236, wird beim Einbau des Schaltungsträgers 21 in ein korrespondierendes Gehäuse mit Befestigungselementen, deren Positionen den Befestigungsöffnungen 214, 224, 234 und 236 entsprechen, eine starke Fixierung des Schaltungsträgers im Bereich der Gruppe 254 erzielt, so dass Schwingungen des Schaltungsträgers gedämpft werden. Das Sensorelement 264 ist derart ausgerichtet, dass seine Außenkanten parallel zu der Verbindungslinie der diagonal gegenüberliegenden Befestigungsöffnungen 214 und 236 und der Verbindungslinie der diagonal angeordneten Befestigungsöffnungen 224 und 234 liegen. Die Vorzugsrichtung des Sensorelements 264 weist demnach einen Winkel von 45° bezüglich der x-Richtung (Fahrtrichtung) auf.

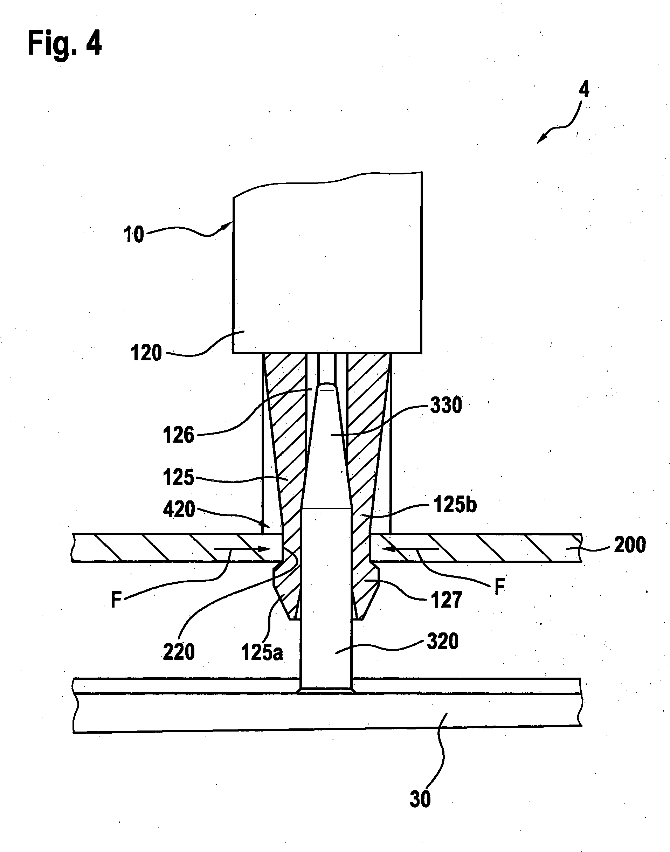

Figur 4 zeigt einen Ausschnitt aus einer erfindungsgemäßen Schaltungsanordnung 4. Dargestellt ist ein Befestigungselement 120, das Teil eines Gehäuseelements 10 ist. Das Befestigungselement 120 weist einen Spreizdom 125 auf, der in vier durch entlang der Längsachse des Spreizdoms 125 verlaufende Schlitze getrennte Segmente unterteilt ist. In dieser Ansicht, sind nur zwei Segmente 125a und 125b sichtbar. Die Segmente des Spreizdoms 125 bilden zwischen sich einen Raum 126 aus. An den freien Enden der Segmente 125a und 125b sind Schnapphaken 127 ausgebildet.

Die Schaltungsanordnung 4 umfasst eine Leiterplatte 200 mit einer Befestigungsöffnung 220, die als kreisförmige Bohrung ausgeführt ist. Das Befestigungselement 120 greift mit dem Spreizdom 125 in die Befestigungsöffnung 220 ein. Durch die Schnapphaken 127 wird beim Aufstecken der Leiterplatte 200 auf den Spreizdom 125 ein definiertes Einrasten erzielt. Ein zusätzliches Gehäuseelement 30 ist auf der dem Gehäuseelement 10 gegenüberliegenden Seite der Leiterplatte 200 angeordnet. Das Gehäuseelement 30 weist als Befestigungselement einen Fixierdom 320 auf, der stiftförmig ausgebildet ist und sich in Richtung der Leitplatte erstreckt. Der Fixierdom greift in den Raum 126 des Spreizdoms ein. Dadurch werden die Segmente des Spreizdoms 125 auseinandergedrückt und eine horizontale Haltekraft F wird auf die Leiterplatte 200 ausgeübt. So wird eine platzsparende Fixierung der Leiterplatte an dem Befestigungselement 120 erzielt. Die Befestigungselemente 120 und 320 bilden somit zusammen mit der Befestigungsöffnung 220 eine Befestigungsstelle 420 aus. Erfindungsgemäß bilden drei oder mehr benachbart angeordnete derartige Befestigungsstellen eine Gruppe von Befestigungsstellen aus. Im Bereich zwischen den Befestigungsstellen kann gemäß den Figuren 2 oder 3 ein elektronisches Bauelement vibrationsgeschützt auf der Leiterplatte 200 angeordnet werden.

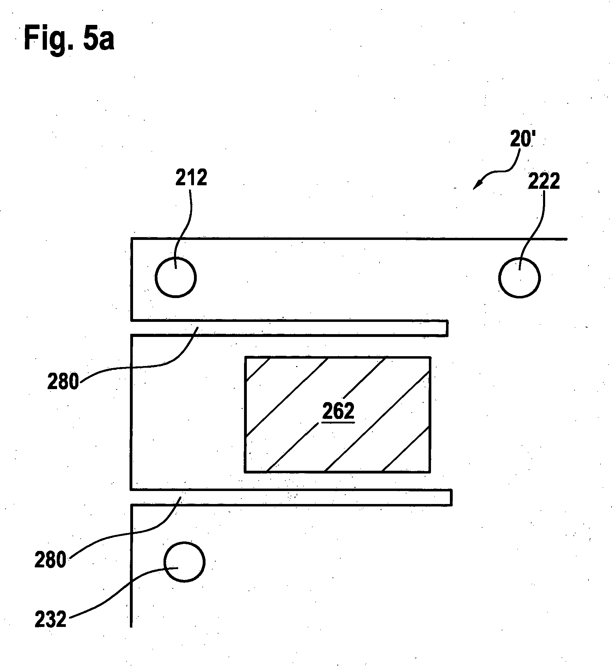

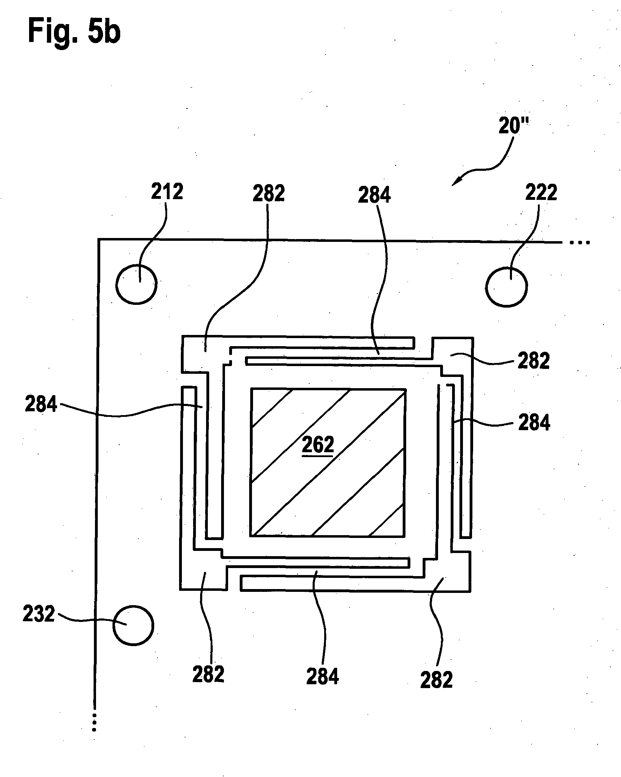

In den Figuren 5a und 5b sind ausschnittsweise Schaltungsträger 20' und 20" dargestellt, die zusätzliche Maßnahmen in Form von Freifräsungen aufweisen, um eine mechanische Entkopplung des Bereichs des Schaltungsträgers 20' und 20" zu erzielen, in dem das Sensorelement 262 angeordnet ist. Der Aufbau entspricht im Wesentlichen dem in Figur 2 dargestellten Aufbau. Gleiche Elemente sind mit denselben Bezugszeichen versehen. In Figur 5a sind im Bereichs des Schaltungsträgers 20' zwischen den Befestigungsöffnungen 212, 222 und 232 in dem das Sensorelement 262 angeordnet ist, zwei Schlitze 280 in dem Schaltungsträger vorgesehen. Die Schlitze 280 verlaufen vom Rand des Schaltungsträgers parallel zu zwei gegenüberliegenden Seiten des Sensorelements 262. Sie erstrecken sich damit in y-Richtung. Durch die Schlitze 280 wird eine mechanische Entkopplung des Sensorelements 262 bewirkt, so dass sich Vibrationen in für die Funktion des Sensorelements 262 störenden Frequenzbereichen, nur noch in geringerem Maße auf das Sensorelement übertragen können.

In Figur 5b sind statt Schlitzen vier Durchbrüche 282 in dem Schaltungsträger 20" vorgesehen. Die Durchbrüche 282 sind derart geformt, dass der Bereich des Schaltungsträgers 20" in dem das Sensorelement 262 angeordnet ist, nur noch über vier dünne mäanderförmige Stege 284 mit dem Rest des Schaltungsträgers 20" verbunden ist. Die Stege 284 haben eine Federwirkung, die eine mechanische Entkopplung des Sensorelements 262 bewirkt.

Zusätzlich oder alternativ zu den dargestellten Beispielen sind weitere Ausgestaltungen von Freifräsungen denkbar, um den Effekt einer mechanischen Entkopplung zu erzielen. So können beispielsweise Freifräsungen entlang einer Diagonalen des Schaltungsträgers vorgesehen sein.

## Patentansprüche

1. Schaltungsträger (20, 200) für eine elektronische Schaltung umfassend Befestigungsöffnungen (210, 212, 220, 222, 230, 232, 240, 242) zum Befestigen des Schaltungsträgers (20) in einem Gehäuse, wobei mindestens zwei der Befestigungsöffnungen (210, 220, 230) eine Gruppe (250) bilden, wobei eine Gruppe dadurch definiert ist, dass die Abstände (d) zwischen jeweils zwei der Befestigungsöffnungen (210, 220, 230), die einer Gruppe (250) angehören, kleiner sind als die Abstände (D) zwischen jeder Befestigungsöffnung (210, 220, 230) der Gruppe (250) und jeder Befestigungsöffnung (240), die nicht der Gruppe angehört **dadurch gekennzeichnet, dass** der Schaltungsträger Freifräsungen (280, 282) aufweist, insbesondere in Form von Schlitzen (280) und/oder Durchbrüchen (282), die im Bereich zwischen den Befestigungsöffnungen (212, 222, 232) einer Gruppe (250) angeordnet sind.

2. Schaltungsträger (20, 200) nach Anspruch 2, **dadurch gekennzeichnet, dass** im Bereich zwischen den Befestigungsöffnungen (210, 220, 230; 212, 222, 232; 214, 224, 234, 236) einer Gruppe (250, 252, 254) ein elektronisches Bauelement (260, 262, 264), insbesondere ein Sensorelement, angeordnet ist.

3. Schaltungsträger (20, 200) nach einem der Ansprüche 1 oder 2, **dadurch gekennzeichnet, dass** eine Gruppe (250, 252) von drei Befestigungsöffnungen (210, 220, 230; 212, 222, 224) gebildet wird, die derart angeordnet sind, dass sie die Ecken eines, insbesondere rechtwinkligen, Dreiecks bilden.

4. Schaltungsträger (20, 200) nach einem der Ansprüche 1 oder 2, **dadurch gekennzeichnet, dass** eine Gruppe (254) von vier Befestigungsöffnungen (214, 224, 234, 236) gebildet wird, die derart angeordnet sind, dass sie die Ecken eines Rechtecks bilden.

5. Schaltungsträger (20, 200) nach einem der Ansprüche 2 bis 4, **dadurch gekennzeichnet, dass** das elektronische Bauelement (260, 262, 264) im Bereich des Schwerpunkts einer Gruppe (250, 252, 254) von Befestigungsöffnungen angeordnet ist.

6. Schaltungsträger (20, 200) nach einem der Ansprüche 2 bis 5, **dadurch gekennzeichnet, dass** das elektronische Bauelement (260, 262, 264) in einem Winkel von 0° oder 45° oder 90° im Bezug auf eine Vorzugsrichtung (x-Richtung) ausgerichtet ist.

7. Schaltungsanordnung (4), umfassend ein Gehäuse umfassend mindestens ein Gehäuseelement (10, 30) mit mindestens drei Befestigungselementen (110, 112, 120, 122, 130, 132, 140, 142, 320) für einen Schaltungsträger, **dadurch gekennzeichnet, dass** mindestens zwei der Befestigungselemente (110, 120, 130) eine Gruppe (150) bilden, wobei eine Gruppe dadurch definiert ist, dass die Abstände (d) zwischen jeweils zwei der Befestigungselemente (110, 120, 130), die derselben Gruppe (150) angehören, kleiner sind als die Abstände (D) zwischen jedem Befestigungselement (110, 120, 130) derselben Gruppe (150) und jedem Befestigungselement (140, 142), das nicht der Gruppe angehört, und einen Schaltungsträger (20, 200) nach einem der Ansprüche 1 bis 6, wobei die Befestigungselemente (110, 112, 120, 122, 130, 132, 140, 142, 320) des Gehäuses mit den Befestigungsöffnungen (210, 212, 220, 222, 230, 232, 240, 242) des Schaltungsträgers derart zusammenwirken, dass Befestigungsstellen (420) ausgebildet sind, an denen der Schaltungsträger in dem Gehäuse befestigt wird, wobei jede Befestigungsstelle (420) durch eine Befestigungsöffnung (210, 212, 220, 222, 230, 232, 240, 242) des Schaltungsträgers und mindestens ein Befestigungselement (110, 112, 120, 122, 130, 132, 140, 142, 320) des Gehäuses gebildet ist.

8. Schaltungsanordnung (4) nach Anspruch 7, **dadurch gekennzeichnet, dass** eine Gruppe (150)von Befestigungselementen mindestens drei Befestigungselemente (110, 120, 130) aufweist.

9. Schaltungsanordnung (4) nach Anspruch 7 oder 8, **dadurch gekennzeichnet, dass** das Gehäuseelement (10) mehrere, insbesondere zwei, Gruppen (150, 152) von Befestigungselementen umfasst (110, 120, 130; 112, 122, 132).

10. Schaltungsanordnung (4) nach einem der Ansprüche 7 bis 9, **dadurch gekennzeichnet, dass** der Abstand (d) zwischen zwei Befestigungselementen (110, 120, 30) einer Gruppe (150) höchstens halb so groß ist wie der Abstand (D) zwischen einem der Befestigungselemente (110, 120, 130) der Gruppe (150) und einem Befestigungselement (140), das nicht der Gruppe angehört.

11. Schaltungsanordnung (4) nach Anspruch 7, **dadurch gekennzeichnet, dass** das Gehäuse an einem Gehäuseelement (10) Befestigungselemente (110, 112, 120, 122, 130, 132, 140, 142) aufweist, die einen Spreizdom (125) umfassen, und die geeignet angeordnet sind, in die in Befestigungsöffnungen 210, 212, 220, 222, 230, 232, 240, 242) des Schaltungsträgers (200) einzugreifen.

12. Schaltungsanordnung (4) nach Anspruch 11, **dadurch gekennzeichnet, dass** wenigstens ein Spreizdom (125) an seinem freien Ende einen Schnapphaken (127) aufweist.

13. Schaltungsanordnung (4) nach einem der Ansprüche 7 bis 12, **dadurch gekennzeichnet, dass** die Schwingungen des Schaltungsträgers (20, 200) im Bereich einer Gruppe von Befestigungsstellen eine höhere Frequenz und/oder eine geringere Amplitude aufweisen, als die Schwingungen des Schaltungsträgers in Bereichen außerhalb einer Gruppe von Befestigungsstellen.

14. Schaltungsanordnung nach einem der Ansprüche 11 bis 13, **dadurch gekennzeichnet, dass** das Gehäuse ein zweites Gehäuseelement (30) mit zweiten Befestigungselementen (320) aufweist, wobei die zweiten Befestigungselemente (320) als Fixierdome ausgebildet sind, die geeignet sind in die Spreizdome (125) einzugreifen und diese auseinanderzudrücken, wodurch eine horizontale Haltekraft auf den Schaltungsträger (200) ausgeübt wird.

## Claims

1. Circuit mount (20, 200) for an electronic circuit, comprising fastening openings (210, 212, 220, 222, 230, 232, 240, 242) for fastening the circuit mount (20) in a housing, wherein at least two of the fastening openings (210, 220, 230) form a group (250), wherein a group is defined by the spacings (d) between in each case two of the fastening openings (210, 220, 230) which belong to one group (250) being smaller than the spacings (D) between each fastening opening (210, 220, 230) of the group (250) and each fastening opening (240) which does not belong to the group, **characterized in that** the circuit mount has milled-out portions (280, 282), in particular in the form of slots (280) and/or apertures (282) which are arranged in the region between the fastening openings (212, 222, 232) of one group (250).

2. Circuit mount (20, 200) according to Claim 1, **characterized in that** an electronic component (260, 262, 264), in particular a sensor element, is arranged in the region between the fastening openings (210, 220, 230; 212, 222, 232; 214, 224, 234, 236) of one group (250, 252, 254).

3. Circuit mount (20, 200) according to either of Claims 1 and 2, **characterized in that** one group (250, 252) is formed by three fastening openings (210, 220, 230; 212, 222, 224) which are arranged in such a way that they form the corners of an, in particular equilateral, triangle.

4. Circuit mount (20, 200) according to either of Claims 1 and 2, **characterized in that** one group (254) is formed by four fastening openings (214, 224, 234, 236) which are arranged in such a way that they form the corners of a rectangle.

5. Circuit mount (20, 200) according to one of Claims 2 to 4, **characterized in that** the electronic component (260, 262, 264) is arranged in the region of the centre of gravity of one group (250, 252, 254) of fastening openings.

6. Circuit mount (20, 200) according to one of Claims 2 to 5, **characterized in that** the electronic component (260, 262, 264) is oriented at an angle of 0° or 45° or 90° in relation to a preferred direction (x direction).

7. Circuit arrangement (4) comprising a housing comprising at least one housing element (10, 30) having at least three fastening elements (110, 112, 120, 122, 130, 132, 140, 142, 320) for a circuit mount, **characterized in that** at least two of the fastening elements (110, 120, 130) form one group (150), wherein a group is defined by the spacings (d) between in each case two of the fastening elements (110, 120, 130) which belong to the same group (150) being smaller than the spacings (D) between each fastening element (110, 120, 130) of the same group (150) and each fastening element (140, 142) which does not belong to the group, and comprises a circuit mount (20, 200) according to one of Claims 1 to 6, wherein the fastening elements (110, 112, 120, 122, 130, 132, 140, 142, 320) of the housing interact with the fastening openings (210, 212, 220, 222, 230, 232, 240, 242) in the circuit mount in such a way that fastening points (420), at which the circuit mount is fastened in the housing, are formed, wherein each fastening point (420) is formed by a fastening opening (210, 212, 220, 222, 230, 232, 240, 242) in the circuit mount and at least one fastening element (110, 112, 120, 122, 130, 132, 140, 142, 320) of the housing.

8. Circuit arrangement (4) according to Claim 7, **characterized in that** one group (150) of fastening elements has at least three fastening elements (110, 120, 130).

9. Circuit arrangement (4) according to Claim 7 or 8, **characterized in that** the housing element (10) comprises a plurality of, in particular two, groups (150, 152) of fastening elements (110, 120, 130; 112, 122, 132).

10. Circuit arrangement (4) according to one of Claims 7 to 9, **characterized in that** the spacing (d) between two fastening elements (110, 120, 130) of one group (150) is at most half the size of the spacing (D) between one of the fastening elements (110, 120, 130) of the group (150) and a fastening element (140) which does not belong to the group.

11. Circuit arrangement (4) according to Claim 7, **characterized in that** the housing has, on a housing element (10), fastening elements (110, 112, 120, 122, 130, 132, 140, 142) which comprise an expanding mandrel (125) and which are arranged such that they are suitable for engaging into the fastening openings (210, 212, 220, 222, 230, 232, 240, 242) in the circuit mount (200).

12. Circuit arrangement (4) according to Claim 11, **characterized in that** at least one expanding mandrel (125) has, at its free end, a snap-action hook (127).

13. Circuit arrangement (4) according to one of Claims 7 to 12, **characterized in that** the vibrations of the circuit mount (20, 200) in the region of a group of fastening points have a higher frequency and/or a lower amplitude than the vibrations of the circuit mount in regions outside a group of fastening points.

14. Circuit arrangement according to one of Claims 11 to 13, **characterized in that** the housing has a second housing element (30) with second fastening elements (320), wherein the second fastening elements (320) are designed as fixing mandrels which are suitable for engaging into the expanding mandrels (125) and pushing said expanding mandrels apart, as a result of which a horizontal retaining force is exerted onto the circuit mount (200).

## Revendications

1. Support de circuit (20, 200) pour un circuit électronique comportant des ouvertures de fixation (210, 212, 220, 222, 230, 232, 240, 242) pour la fixation du support de circuit (20) dans un boîtier, au moins deux des ouvertures de fixation (210, 220, 230) formant un groupe (250), un groupe étant défini par le fait que les distances (d) entre deux des ouvertures de fixation (210, 220, 230) respectives qui appartiennent à un groupe (250) sont inférieures aux distances (D) entre chaque ouverture de fixation (210, 220, 230) du groupe (250) et chaque ouverture de fixation (240) qui n'appartient pas au groupe,
**caractérisé en ce que** le support de circuit comprend des fraisages libres (280, 282), en particulier sous forme de fentes (280) et/ou de passages (282) qui sont disposé(e)s dans la région entre les ouvertures de fixation (212, 222, 232) d'un groupe (250).

2. Support de circuit (20, 200) selon la revendication 1, **caractérisé en ce qu'**un composant électronique (260, 262, 264), en particulier un élément de capteur, est disposé dans la région entre les ouvertures de fixation (210, 220, 230 ; 212, 222, 232 ; 214, 224, 234, 236) d'un groupe (250, 252, 254).

3. Support de circuit (20, 200) selon l'une quelconque des revendications 1 et 2, **caractérisé en ce qu'**un groupe (250, 252) de trois ouvertures de fixation (210, 220, 230 ; 212, 222, 224) est formé, lesquelles ouvertures de fixation sont disposées de telle sorte qu'elles forment les coins d'un triangle en particulier rectangle.

4. Support de circuit (20, 200) selon l'une quelconque des revendications 1 et 2, **caractérisé en ce qu'**un groupe (254) de quatre ouvertures de fixation (214, 224, 234, 236) est formé, lesquelles ouvertures de fixation sont disposées de telle sorte qu'elles forment les coins d'un rectangle.

5. Support de circuit (20, 200) selon l'une quelconque des revendications 2 à 4, **caractérisé en ce que** le composant électronique (260, 262, 264) est disposé dans la région du barycentre d'un groupe (250, 252, 254) d'ouvertures de fixation.

6. Support de circuit (20, 200) selon l'une quelconque des revendications 2 à 5, **caractérisé en ce que** le composant électronique (260, 262, 264) est orienté suivant un angle de 0° ou de 45° ou de 90° par rapport à une direction préférentielle (direction x).

7. Ensemble de circuit (4), comportant un boîtier comportant au moins un élément de boîtier (10, 30) doté d'au moins trois éléments de fixation (110, 112, 120, 122, 130, 132, 140, 142, 320) pour un support de circuit, **caractérisé en ce qu'**au moins deux des éléments de fixation (110, 120, 130) forment un groupe (150), un groupe étant défini par le fait que les distances (d) entre deux des éléments de fixation (110, 120, 130) respectifs qui appartiennent au même groupe (150) sont inférieures aux distances (D) entre chaque élément de fixation (110, 120, 130) du même groupe (150) et chaque élément de fixation (140, 142) qui n'appartient pas au groupe, et un support de circuit (20, 200) selon l'une quelconque des revendications 1 à 6, les éléments de fixation (110, 112, 120, 122, 130, 132, 140, 142, 320) du boîtier coopérant avec les ouvertures de fixation (210, 212, 220, 222, 230, 232, 240, 242) du support de circuit de telle sorte que des points de fixation (420) soient réalisés, au niveau desquels le support de circuit est fixé dans le boîtier, chaque point de fixation (420) étant formé par une ouverture de fixation (210, 212, 220, 222, 230, 232, 240, 242) du support de circuit et au moins un élément de fixation (110, 112, 120, 122, 130, 132, 140, 142, 320) du boîtier.

8. Ensemble de circuit (4) selon la revendication 7, **caractérisé en ce qu'**un groupe (150) d'éléments de fixation comprend au moins trois éléments de fixation (110, 120, 130).

9. Ensemble de circuit (4) selon la revendication 7 ou 8, **caractérisé en ce que** l'élément de boîtier (10) comporte plusieurs, en particulier deux, groupes (150, 152) d'éléments de fixation (110, 120, 130 ; 112, 122, 132).

10. Ensemble de circuit (4) selon l'une quelconque des revendications 7 à 9, **caractérisé en ce que** la distance (d) entre deux éléments de fixation (110, 120, 130) d'un groupe (150) est au plus égale à la moitié de la distance (D) entre l'un des éléments de fixation (110, 120, 130) du groupe (150) et un élément de fixation (140) qui n'appartient pas au groupe.

11. Ensemble de circuit (4) selon la revendication 7, **caractérisé en ce que** le boîtier comprend des éléments de fixation (110, 112, 120, 122, 130, 132, 140, 142) sur un élément de boîtier (10), lesquels éléments de fixation comportent un mandrin d'écartement (125), et lesquels sont disposés de manière appropriée pour venir en prise dans les ouvertures de fixation (210, 212, 220, 222, 230, 232, 240, 242) du support de circuit (200).

12. Ensemble de circuit (4) selon la revendication 11, **caractérisé en ce qu'**au moins un mandrin d'écartement (125) comprend un crochet d'encliquetage (127) à son extrémité libre.

13. Ensemble de circuit (4) selon l'une quelconque des revendications 7 à 12, **caractérisé en ce que** les vibrations du support de circuit (20, 200) dans la région d'un groupe de points de fixation présentent une fréquence plus élevée et/ou une amplitude plus faible que les vibrations du support de circuit dans des régions à l'extérieur d'un groupe de points de fixation.

14. Ensemble de circuit selon l'une quelconque des revendications 11 à 13, **caractérisé en ce que** le boîtier comprend un deuxième élément de boîtier (30) doté de deuxièmes éléments de fixation (320), les deuxièmes éléments de fixation (320) étant réalisés sous forme de mandrins de fixation qui sont appropriés pour venir en prise dans les mandrins d'écartement (125) et pour écarter ceux-ci, de sorte qu'une force de retenue horizontale soit exercée sur le support de circuit (200).
